# EUROPEAN PATENT SPECIFICATION

(11) **EP 2 058 993 B1**
(45) Date of publication and mention of the grant of the patent: **07.04.2010**
(21) Application number: 07291354.4
(22) Date of filing: 12.11.2007
(51) Int. Cl.: H04L 25/03, H04L 27/00

(54) **Radio frequency transmitter**
Funkfrequenzsender
Transmetteur de fréquence radio

(43) Date of publication of application: 13.05.2009
(73) Proprietor: LUCENT TECHNOLOGIES INC., Murray Hill NJ 07974-0636 (US)
(72) Inventor: Pivit, Florian, Dublin 15 (IR); Hesselbarth, Jan, 8482 Sennhof (CH); Fischer, Georg, 90425 Nürnberg (DE); Chalermwisutkul, Suramate, Chonburi (TH)
(74) Representative: Schmidt, Werner Karl

(56) References cited:
- EP-A- 0 058 081
- WO-A-03/021766
- US-A1- 2006 050 810

## Description

The present invention relates to a radio frequency transmitter, in particular a radio frequency transmitter comprising a switch mode power amplifier for amplification of an input signal, and a method of amplifying an input signal yin such a radio frequency transmitter.

The efficiency of power amplifiers in base stations (= BS) for mobile communications is of high importance: inefficient power amplifiers increase the operational costs due to higher energy consumption, as well as the capital costs for cooling and ventilation equipment and for stronger power supplies. Inefficiency causes increased operating temperatures of components, and leads to premature component failure.

The currently used power amplifiers for base stations are analog power amplifiers. The structure of the analog signals used in mobile communication systems like CDMA 2000 and UMTS is of such nature that they not only require a highly linear dynamic range but also a back-off of about 6 dB to 11 dB (CDMA = Code Division Multiple Access; UMTS = Universal Mobile Telecommunications System). These requirements can only be achieved by sacrificing on efficiency, if standard technologies like LDMOS transistors are used (LDMOS = Laterally Diffused Metal-Oxide Semiconductor).

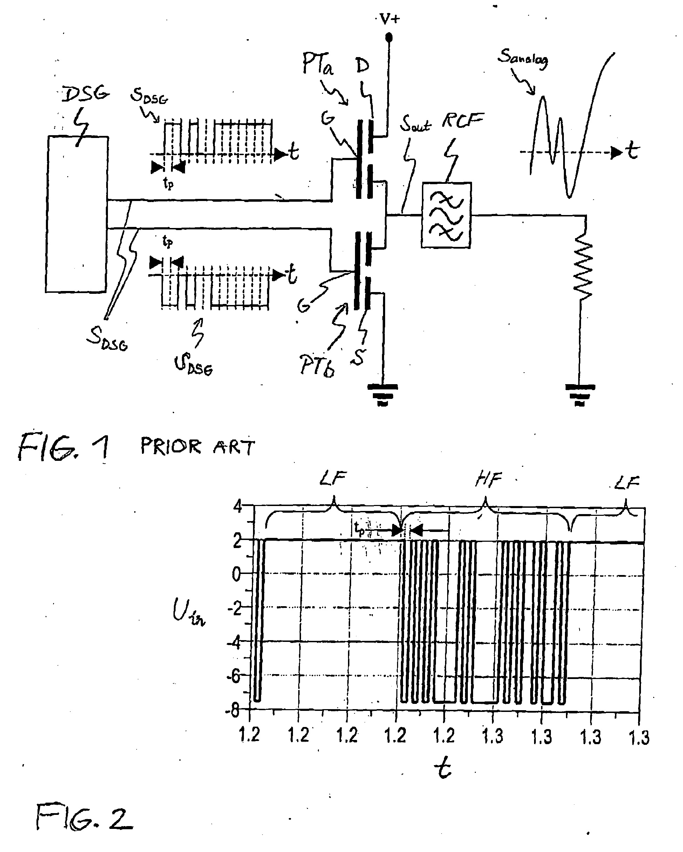

A switch mode power amplifier is an electronic amplifier where the active devices are operated in on/off mode, i.e., as switches. Patent application WO 03/021766 A2 (Tropian Inc.) published 13 March 2003 discloses a modulator using a switch mode power amplifier. In Fig. 1, the typical set-up of a switch mode power amplifier is shown. Unlike an analog amplifier, switch mode power amplifiers are driven by a square pulsed input signal. The efficiency of switch mode power amplifiers - also called Class-S-amplifiers - using transistors is dependent on the switching speed of the transistors and of the form of the pulse sequence which is used to drive the transistor.

A digital signal generator DSG generates a differential-mode, rectangular pulsed bit stream signal S_{DSG}. Here, the digital low power input signal S_{DSG} to the amplifier is of a "Delta-Sigma-modulated" type. Such a signal is a sequence of pulses of duration of multiples of tₚ. This signal drives two power transistors PTₐ and PT_{b}, arranged as a Complementary MOSFET (= CMOS; MOSFET = metal oxide semiconductor field-effect transistor). Generally, a CMOS is designed with a p-channel MOSFET PTₐ and a n-channel MOSFET PT_{b} on the same chip. The transistor configuration shown in Fig. 1 is an inverting circuit which is the basic component of CMOS logic gates. Only one transistor is "on" at any time, but since the other one is "off", no current can flow in the quiescent condition. Current only flows during switching and this combination thus has a very low input power drain. However, this also means that the current increases with the clock speed.

The pulsed bit stream signal S_{DSG} is fed into the gates G of the MOSFET transistors PTₐ, PT_{b}. The drain D of the p-channel MOSFET PTₐ is connected to a voltage V+, the source S of the n-channel MOSFET PT_{b} is connected to the earth ground. These transistors act as switches and are, in the ideal case, simply turned "on" and "off" to amplify the digital signal. At the output of the amplifier, a reconstruction filter RCF converts the amplified rectangular pulsed output signal Sₒᵤₜ back into the analog high power output signal S_{analog}. The reconstruction filter RCF may comprise a low pass filter.

Insight into the operation of radio frequency power amplifiers using bandpass Delta-Sigma modulators is provided, e.g., by Shawn P. Stapleton, "High Efficiency RF Power Amplifiers Using Bandpass Delta-Sigma Modulators", Design Seminar, Agilent Technologies, Inc., Santa Rosa (California), USA, pp. 1-22.

It is the object of the present invention to improve the efficiency of a switch mode power amplifier in the radio frequency range.

The object of the present invention is achieved by a radio frequency transmitter comprising a digital signal generator with a generation unit adapted to generate a pulsed bit stream signal and a switch mode radio frequency power amplifier with a transistor circuit adapted to amplify an input signal, whereby the digital signal generator further comprises a control unit adapted to detect in said pulsed bit stream signal a sequence of a constant signal height longer than a predefined threshold and initiate, upon detection of said sequence, a generation of a modified pulsed bit stream signal by an insertion of one or more notches in said sequence, said notches interrupting said sequence by a signal of a signal height different from the signal height of the sequence, and that the radio frequency transmitter further comprises connecting means adapted to provide said transistor circuit with said modified pulsed bit stream signal as the input signal. The object of the present invention is further achieved by a method of amplifying an input signal in a radio frequency transmitter comprising a switch mode radio frequency power amplifier with a transistor circuit, whereby the method comprises the steps of detecting in a pulsed bit stream signal a sequence of a constant signal height longer than a predefined threshold, initiating, upon detection of said sequence, a generation of a modified pulsed bit stream signal by an insertion of one or more notches in said sequence, said notches interrupting said sequence by a signal of a signal height different from the signal height of the sequence, and providing said transistor circuit with said modified pulsed bit stream signal as the input signal.

For the purpose of this description, a switch mode radio frequency power amplifier is a switch mode power amplifier which is adapted to amplify radio frequency signals. Furthermore, the term "digital signal generator" comprises a signal generator with a generation unit adapted to generate a pulsed bit stream signal which is discrete with respect to the values of the bit stream signal, i.e., the signal height, and discrete with respect to time. However, the term "digital signal generator" may also comprise a semi-digital generator, i.e., a signal generator with a generation unit adapted to generate a pulsed bit stream signal which is discrete with respect to the values of the bit stream signal, i.e., the signal height, and continuous with respect to time. It is possible that such a semi-digital generator producing a non time-discrete signal is particularly advantageous within the frame of this present invention,

The invention addresses issues which are associated with the use of switch mode power amplifiers in the radio frequency range, New methods for the amplification of RF signals for base stations have been looked for. A new type of semiconductors, the GaN-transistor, is emerging into the market and will be used in increasing numbers for conventional linear power amplifiers (GaN = Gallium nitride). The GaN-transistors can and will also be used in switch-mode-power-amplifiers. This kind of amplifier is well known, but has not been used for power amplifiers in base stations yet, since the required switching frequency is too high for today's LDMOS transistors. This is the case since the digital input signal requires an over-sampling rate of two to four times the RF-carrier-frequency, resulting in a switching rate of over 8 GHz for mobile communication systems like CDMA and UMTS (RF = Radio Frequency). The use of the new, now emerging high-power GaN transistors will make it possible to build switch-mode-power-amplifiers for such frequency ranges and applications.

In Fig. 2, a sequence of a Delta-Sigma-modulated UMTS input signal for a class-S amplifier is shown. Fig. 2 gives a voltage Uᵢₙ of the input signal, in units of Volt, as a function of time t, given in unit of µs. The input signal is a sequence of pulses of duration of multiples of a time unit tₚ. The time unit tₚ constitutes a building block of the input signal. The different parts of the signal contain different spectral components. High frequent changes between high and low signal levels contain high frequency spectral components HF, and long sequences of equal amplitude contain more low frequency spectral components LF.

It has been shown that the operational state of the transistor depends on the frequency range at which it is operated. The long sequences LF of input pulses of the same amplitude result in low frequency spectral components of the input signal, which lead to a reduction in efficiency since the operational point of the amplifier changes opposed to the operational point at high frequencies.

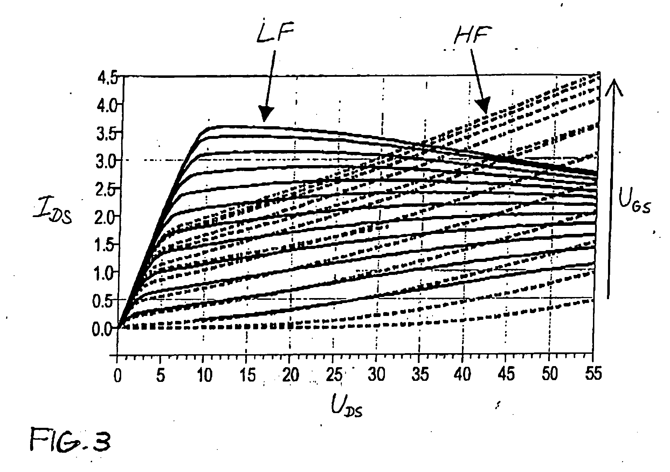

As an example, Fig. 3 shows a drain source current I_{DS} of a GaN transistor as a function of a drain source voltage U_{DS} applied for low-frequency input signals (solid lines) and high-frequency input signals (dashed lines), each of the low/high frequency input signals associated with a different gate source voltage U_{GS}. Both for low and high frequency signals, at a given value of the drain source voltage U_{DS}, an input signal with a smaller drain source current I_{DS} is associated with a smaller gate source voltage U_{GS} than an input signal with a larger drain source current I_{DS}. The drain source current I_{DS} is given in units of Ampere, the gate source voltage U_{GS} in units of Volt. Fig. 3 illustrates the changing characteristic of the transistor if operated at rather low frequencies instead of high frequencies. This effect is called "low frequency dispersion". This makes clear that a Delta-Sigma-modulated signal inherently causes low frequency dispersion in the transistor, since it contains low frequency spectral components as well as high ones

The invention addresses the issue of this "low frequency dispersion" by altering the Delta-Sigma-modulated input signal in such a way that sequences of equal signal level are broken up if the sequence length exceeds a predefined value. By inserting short notches/pulses in long signal sequences of equal amplitude in the input signal, the very low spectral components of the input signal are reduced, therefore, by interleaving or notching the input signal with short pulses, the dispersion effect in the GaN-transistor is minimised or avoided.

Preferably, the duration of a notch for insertion into the input signal is chosen such that the notch does impact the transistor circuit but is not able to pass the reconstruction filter RCF behind the switch mode radio frequency power amplifier. This effect is achieved by generating a sufficiently short notch. If the notch is chosen so short that it cannot pass the reconstruction filter RCF, the notch cannot affect the analog output signal of the reconstruction filter RCF. Preferably, the reconstruction filter RCF comprises a low pass filter to block the notch from passing the reconstruction filter RCF.

The notching can be achieved in two ways:
a) digital notching: by digital signal processing in the digital signal generator which generates the digital signal to drive the SMPA,
b) digital/analog notching: by implementing a notching circuit at a signal input of the PA transistor, e.g., at the gate of the MOSFET (PA = Power Amplifier).
Which notching scheme is used, depends on the modulation scheme as well as on the capability of the digital signal generator and of the error correction used on the transmission.

There are two major aspects to the invention. First, it represents a fast, low cost and adaptive way to perform digital and mixed digital/analog, respectively, signal pre-distortion for switch mode power amplifiers. Second, it enables the implementation of highly efficient switch mode power amplifiers which suffer from low frequency dispersion effects without requiring faster sampling rates in the digital signal generator.

The present invention overcomes the low frequency dispersion effect in switch mode power amplifiers when driven by Delta-Sigma-modulated signals. Furthermore, the invention makes use of the knowledge about the signal the DSG generates, and uses this knowledge to avoid long sequences in the input signal.

The invention results in a minimized circuitry for the implementation of this pre-distortion. Also, the invention allows a high degree of freedom of the method for an efficient adaptation for different kind of power amplifiers and transistors, respectively. In addition, the invention applies a mixed digital/analog approach: easy control of the input signal in the digital domain and fast, cheap and easy implementation of the notching circuit in analog technology.

Further advantages are achieved by the embodiments of the invention indicated by the dependent claims.

According to a preferred embodiment of the invention, the control unit triggers, when detecting said sequence, the generator unit to insert said one or more notches. For an insertion of said one or more notches, the generator unit digitally creates one or more signal height discontinuities within the sequence. The signal height discontinuities may be constituted by a significantly higher or lower signal level than the signal height of the sequence. By inserting the one or more notches into the sequence, a modified pulsed bit stream signal is created out of the pulsed bit stream signal that has been initially created by the generator unit. After the generation of the a modified pulsed bit stream signal, the control unit sends the modified pulsed bit stream signal via the connecting means to the transistor circuit of the switch mode power amplifier. This embodiment is associated with the aforementioned notching method a) "digital notching ". The connecting means may be conductive paths or electric circuitry (wires, cables, strip conductors, printed circuit board track, etc.) used in electronics,

According to another preferred embodiment of the invention, the control unit initiates, when detecting said sequence, a generation of a trigger signal. The connecting means comprise a switching element. It is possible that the switching element is an integrated part of a printed circuit board track serving as connecting means. The switching element is controlled by the trigger signal for the insertion of said notches. Preferably, the generated trigger signal is sent to the switching element, being part of the connecting means. The switching element is adapted to receive said trigger signal. When the switching element receives the trigger element, it executes one or more switches which result in the insertion of said notches. This embodiment is associated with the aforementioned notching method b) "digital/ analog notching".

This embodiment has the advantage, that it allows a more flexible timing of the notches as well as a free shaping of the notch. This depends on the capabilities of the switching element. This embodiment allows to place and to shape the notches such that the error in the analog signal output is minimised. This embodiment combines a digital signal processing approach with an analog circuitry to pre-distort the digital input signal of the switch mode power amplifier such that the low-frequency-dispersion effect is reduced and therefore the efficiency of the amplifier does not decrease.

It is possible that the switching element is a second transistor adapted to receive said trigger signal and switch, triggered by the receipt of said trigger signal, the transistor circuit for generation of said one or more notches. It is possible that the second transistor is adapted to switch, triggered by the receipt of said trigger signal, a gate of the transistor circuit to a different potential for generation of said one or more notches. Preferably, said second transistor is smaller and faster than the transistors used in the transistor circuit of the switch mode power amplifier. This second transistor does not have to switch high currents and can therefore be very fast.

In a preferred embodiment, the control unit triggers, upon detection of said sequence, the digital signal generator to generate an indicator signal, the indicator signal signalising the beginning and the duration of the detected sequence. Preferably, the signal height of the indicator signal is at a first level, e.g., at zero, if no sequence is detected. If the sequence is detected, the indicator signal jumps at the beginning of the sequence from the first level to a second level, e.g., a non-zero signal height. The indicator signal stays at the second level until the end of the sequence and jumps then back to the first level.

The control unit triggers that the generated indicator signal is sent via the connecting means to a pulse generator. The pulse generator generates, triggered by said indicator signal, one or more pulses as the trigger signal. As aforementioned, the trigger signal, i.e., the one or more pulses, is sent to the switching element which is part of the connecting means.

According to another preferred embodiment of the invention, the radio frequency transmitter comprises a delay unit. The generated trigger signal is delayed before reaching the switching element so that the insertion of said notches occurs at a predefined time. This can be used to optimise the timing of the notching within the sequence.

Preferably, a duration of said one or more notches is shorter than a duration of a pulse of the pulsed bit stream signal.

According to another preferred embodiment of the invention, the transistor circuit consists of one or more Gallium nitride transistors. The transistor circuit may comprise, e.g., a circuit made from GaN transistors.

Preferably, the control unit is adapted to compensate the insertion of said one or more notches in said sequence by triggering a corresponding extension of the pulsed bit stream signal so that an overall energy content of the pulsed bit stream signal is conserved. Each inserted notch decreases the energy content of the pulsed bit stream signal. Therefore, the energy content can be brought to its initial value by appending, e.g., to the end of the sequence, a signal with an energy content equivalent to the energy content that was "cut out" (removed) by the notches.

It is also possible that the control unit controls a shape of the one or more notches dependent on a type of the switch mode power amplifier. The notch can be either of a rectangular shape, or any other shape, depending which shape serves the purpose best, depending on the individual power transistor type. The notch does not necessarily have to reach zero, but any other level, which is required to achieve the desired effect. The length of the notch can have any duration.

These as well as further features and advantages of the invention will be better appreciated by reading the following detailed description of presently preferred exemplary embodiments taken in conjunction with accompanying drawings of which:
- Fig. 4: is a block diagram of a radio frequency transmitter according to an embodiment of the invention;
- Fig. 5a: is a diagram of a pulsed bit stream signal as initially generated by a digital signal generator;
- Fig. 5b: is a diagram of a modified pulsed bit stream signal comprising two notches;
- Fig. 6: is a diagram of a pulsed bit stream signal as initially generated by the digital signal generator, and two modified pulsed bit stream signals comprising notches of different shape;
- Fig. 7: is a block diagram of a radio frequency transmitter according to another embodiment of the invention;
- Fig. 8: is a diagram of a pulsed bit stream signal as initially generated by a digital signal generator, an indicator signal, and pulses generated by a pulse generator; and
- Fig. 9: is a sequence of a delta-sigma modulated UMTS signal without and with, respectively, notches.

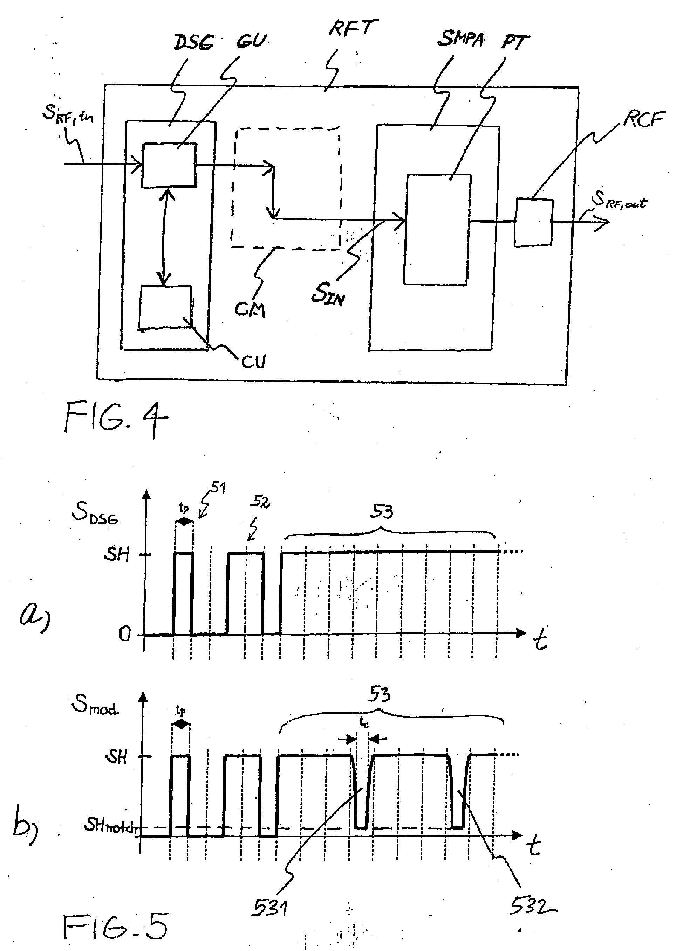

Fig. 4 shows a radio frequency transmitter RFT comprising a digital signal generator DSG with a generation unit GU and a control unit CU. The radio frequency transmitter RFT further comprises a switch mode power amplifier SMPA with a transistor circuit PT, and connecting means CM.

The control unit CU is composed of one or several interlinked computers, i.e., a hardware platform, a software platform basing on the hardware platform and several application programs executed by the system platform formed by the software and hardware platform. The functionalities of the control unit CU are provided by the execution of these application programs. The application programs or a selected part of these application programs constitute a computer software product providing a control service as described in the following, when executed on the system platform. Further, such computer software product is constituted by a storage medium storing these application programs or said selected part of application programs.

The radio frequency transmitter RFT receives a radio frequency signal input S_{RF,in} and feeds the radio frequency signal input S_{RF,in} into the digital signal generator DSG. The radio frequency signal input S_{RF},ᵢₙ can comprehend an analog or a digital signal. The radio frequency signal input S_{RF,in} is converted to a digital pulsed bit stream signal S_{DSG} by the generator unit GU. The control unit CU monitors the digital pulsed bit stream signal S_{DSG} generated by the generator unit GU. The monitoring of the digital pulsed bit stream signal S_{DSG} can be achieved by delaying the pulsed bit stream signal S_{DSG} for a short time period (∼ µs) and analysing the signal S_{DSG} during this time period. If the control unit CU detects a sequence of a constant signal height longer than a predefined threshold, the control unit triggers the generator unit GU to insert at least one notch into the sequence. A typical threshold may be 10 sampling units, I.e. 10 x tₚ. By the insertion of the one or more notches in said sequence, a modified pulsed bit stream signal S_{mod} is generated from the digital pulsed bit stream signal S_{DSG}.

The modified pulsed bit stream signal S_{mod} is transmitted via the connecting means CM from the digital signal generator DSG to the switch mode power amplifier SMPA. The modified pulsed bit stream signal S_{mod} is applied to the transistor circuit PT for amplification. After its amplification, the amplified pulsed bit stream signal is fed into a reconstruction filter RCF where an analog signal is generated from the amplified pulsed bit stream signal. This analog signal leaves the radio frequency transmitter RFT as an analog radio frequency signal output S_{RF,out}.

Fig. 5a shows a digital pulsed bit stream signal S_{DSG} generated by the generator unit GU as a function of time t. The building block of the pulsed bit stream signal S_{DSG} is a rectangular signal bit with a duration of tₚ and a signal height SH. Therefore, the pulsed bit stream signal S_{DSG} toggles between zero and the signal height SH. First, the pulsed bit stream signal S_{DSG}, shows a first sequence 51 with a duration tₚ and the signal height SH. After that sequence 51, there is a pause with zero signal for a duration of 2 x tₚ. After this pause, the pulsed bit stream signal S_{DSG} shows a second sequence 52 with a duration 2 x tₚ and the signal height SH. After that sequence 52, there is a pause with zero signal for a duration of tₚ. After the pause, the pulsed bit stream signal S_{DSG} shows a third sequence 53 with duration of at least 9 x tₚ and the signal height SH.

Let us assume that an operator of a radio frequency transmitter RFT has pre-set a threshold of 5 x tₚ. The control unit CU continuously monitors the digital pulsed bit stream signal S_{DSG} and compares the duration of the sequences 51, 52, 53 with the pre-set threshold value. When detecting that the duration of the third sequence 53 is above the pre-set threshold value, the control unit CU triggers the generator unit GU to amend the pulsed bit stream signal S_{DSG} by inserting two notches 531 and 532 into the third sequence 53, thus generating a modified pulsed bit stream signal S_{mod},

Fig. 5b shows the modified pulsed bit stream signal S_{mod} generated by the generator unit GU as a function of time t. In the modified pulsed bit stream signal S_{mod}, the third sequence 53 has been modified by the insertion of the two notches 531 and 532. The signal height SH_{notch} of the notches 531 and 532 is significantly smaller than the signal height SH of the third sequence 53, but greater than the zero signal. Each of the notches 531 and 532 has a duration tₙ whereby tₙ < tₚ. If the edges of the notches 531 and 532 are not vertical, the duration tₙ of the notches 531 and 532 may be defined as a geometric or analytic value associated with the notches 531 and 532. For example, a FWHM value may be used, wherein the maximum of the notches 531 and 532 may be measured from the signal height SH of the sequence to the signal height SH_{notch} of the notches 531 and 532 (FWHM = Full Width at Half Maximum).

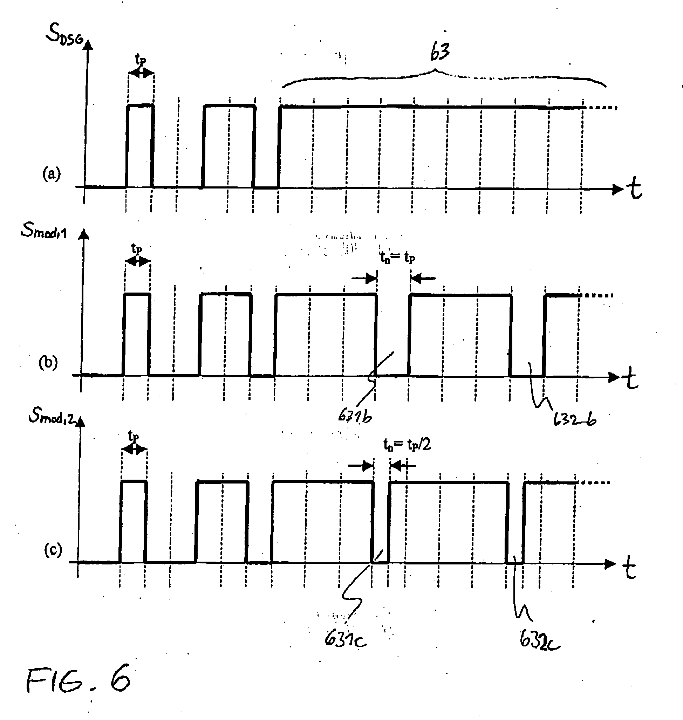

Fig. 6a shows a digital pulsed bit stream signal S_{DSG} generated by the generator unit GU, as a function of time t. Fig. 6b shows a first modified pulsed bit stream signal S_{mod,1} gained from a modification of the digital pulsed bit stream signal S_{DSG} shown in Fig. 6a, as a function of time t. Fig. 6c shows a second modified pulsed bit stream signal S_{mod,2} gained from a modification of the digital pulsed bit stream signal S_{DSG} shown in Fig. 6a, as a function of time t.

If the digital signal generator DSG gets aware of a long "high" signal sequence 63, it inserts, according to the sequence length, "low" pulses (notches 631b, 632b, 631c, 632c) of duration tₙ into the bit stream. This of course causes an error in the output signal. The severeness of this error depends on the modu lation scheme and on the oversampling rate of the digital signal: the higher the oversampling rate, the shorter the notch will and therefore the lower its impact will be. The impact or its correction depends highly on the used communication system. According to the length of the "high" sequence 63, the digital signal generator DSG can generate different widths and rates of "low" notches, depending on the acceptable error in the output signal and on the speed of the transistor circuit PT. Fig. 6b shows notches 631b, 632b with a duration tₙ =tₚ, wherein tₚ is the duration of the building blocks of the pulsed bit stream signal S_{DSG}, i.e., the pulse length of the pulsed bit stream signal S_{DSG}. Fig. 6c shows notches 631c, 632c with a duration tₙ=½ tₚ.

If the notches 631, 632 of a duration of m x tₚ with m = [1, 2, 3,...] become too long, the error in the output signal will be too large, so a higher oversampling rate will be necessary to reduce the notch width tₙ. This requires a faster and therefore more expensive digital signal generator DSG as well as a faster transistor circuit PT.

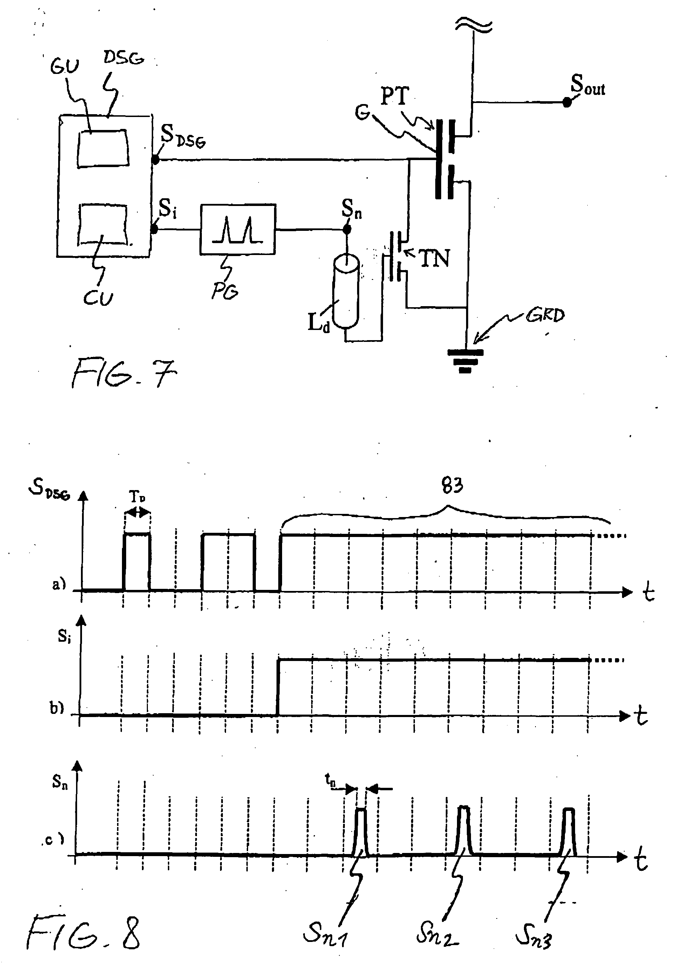

Fig. 7 shows another embodiment of a radio frequency transmitter RFT, associated with the aforementioned notching method b) "digital/ analog notching". The radio frequency transmitter RFT comprises a digital signal generator DSG with a generator unit GU and a control unit CU, a pulse generator PG, a delay line L_{d}, a switching element TN, and a power transistor PT as transistor circuit of the switch mode power amplifier. Like in the merely "digital notching" method a), the control unit CU of the digital signal generator DSG recognises long "high" signal sequences in the output of the generator unit GU, i.e., in the pulsed bit stream signal S_{DSG}. When detecting a sequence exceeding the predefined threshold, the control unit CU triggers the generator unit GU to additionally generate an indicator signal Si, which is used as an indicator for the notch insertion. This makes use of the knowledge of the digital signal generator DSG about the generated signal S_{DSG}.

The indicator signal Sᵢ is generated by the digital signal generator DSG as a gap-insertion-trigger signal. This signal causes a pulse generator PG, e.g., a step recovery diode, to generate fast pulses Sₙ. The trigger pulses Sₙ are delayed, e.g. by a delay line Ld, before triggering the switching element TN, here embodied by a transistor. Each of the trigger pulses Sₙ triggers the second, smaller and faster transistor TN to switch a gate G of the power transistor PT to a potential GRD, i.e., a so-called pull-down of the gate G. The potential GRD may be the ground potential (earth). Alternatively, the potential GRD may be any other potential.

The notches are inserted into the output signal S_{DSG} of the digital signal generator DSG by this pull-down of the gate G. This small pull-down-transistor TN does not have to switch high currents and can therefore be very fast. The duration of these pull-downs can be of a very short duration tₙ < tₚ.

By the choice of the potential GRD, the signal height SH_{notch} of the notch can be adjusted. Preferably, the potential GRD is chosen such that the resulting signal height SH_{notch} is in conformance with an optimal signal pre-distortion, optimised between an unwanted signal distortion and the desired effects of notching, e.g., to avoid the low frequency dispersion.

Fig. 8a shows a digital pulsed bit stream signal S_{DSG} generated by the generator unit GU, as a function of time t. The digital pulsed bit stream signal S_{DSG} comprises a sequence 83 exceeding a pre-set length threshold. Fig. 8b shows an indicator signal Sᵢ by the digital signal generator DSG, as a function of time t. Fig. 8c shows three pulses Sₙ₁, Sₙ₂, Sₙ₃ generated by the pulse generator PG, as a function of time t.

The indicator signal Sᵢ is timed to set in at the moment when the sequence 83 starts. Triggered by the indicator signal Sᵢ, the pulse generator PG generates the three pulses Sₙ₁, Sₙ₂, Sₙ₃ of duration tₙ. The trigger pulses Sₙ are delayed by the delay line Ld, such that the pull down of the gate G of the power transistor PT occurs at a specific time within the long sequence S_{DSG}. This delay mechanism can be used to optimise the timing of the notching within the sequence 83. By changing the pulse repetition frequency and by shaping the notch's width and deepness, the notch can be optimised to achieve best efficiency versus minimal output signal distortion, e.g., by using a Gaussian shaped notch, since it has the lowest possible time bandwidth product.

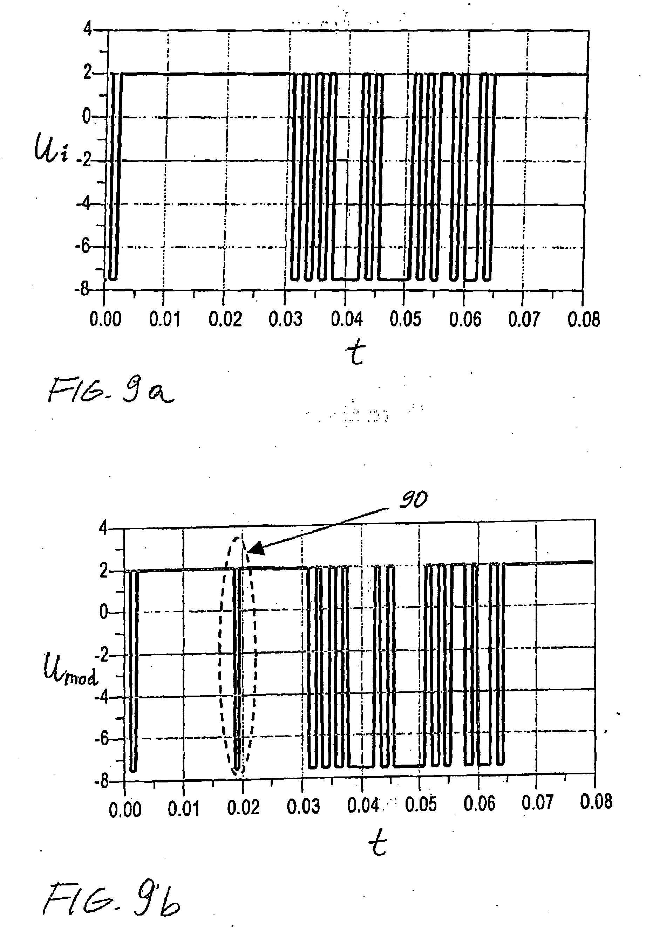

Fig. 9 shows the effect of the concept in the following simulation results generated in a circuit simulator: In Fig. 9a, a sequence of a Delta-Sigma-modulated UMTS signal Uᵢ is shown. The signal Uᵢ, given in the unit of Volt, is shown as a function of time, given in the unit of µs. This signal Uᵢ is applied to a switch-mode-amplifier containing a GaN HEMT transistor model (HEMT = High Electron Mobility Transistor). The applied DC power to the amplifiers is 15.596 W and the analog RF output power is 1.136 W, resulting in an efficiency of 7.287 %.

In Fig. 9a, a sequence of a Delta-Sigma-modulated UMTS signal U_{mod} is shown. The signal U_{mod}, given in the unit of Volt, is shown as a function of time, given in the unit of µs. The modulated UMTS signal U_{mod} has been generated from the UMTS signal Uᵢ shown in Fig. 9a by interleaving a pulse/ notch 90 of a duration tₚ/2 in the long "low" sequence between t = 0.0002 µs and t = 0.0102 µs. As in the aforementioned case, this signal U_{mod} is applied to a switch-mode-amplifier containing a GaN HEMT transistor model. The applied DC power is 16.449 W and the analog RF output power increases to 1.663 W, which leads to an efficiency of 10.11 %.

As a comparison between Fig. 9a and Fig. 9b shows, the efficiency is increased by a factor of 1.387 by the insertion of the notch 90. This shows the significant impact of the proposed invention on the efficiency of a switch-mode-power-amplifier.

## Claims

1. A radio frequency transmitter (RFT) comprising a digital signal generator (DSG) with a generation unit (GU) adapted to generate a pulsed bit stream signal (S_{DSG}) and a switch mode radio frequency power amplifier (SMPA) with a transistor circuit (PT) adapted to amplify an input signal (S_{IN}),
**characterised in**
**that** the digital signal generator (DSG) further comprises a control unit (CU) adapted to detect in said pulsed bit stream signal (S_{DSG}) a sequence (53) of a constant signal height (SH) longer than a predefined threshold and initiate, upon detection of said sequence (53), a generation of a modified pulsed bit stream signal (S_{mod}) by an insertion of one or more notches (531, 532) in said sequence (53), said notches (531, 532) interrupting said sequence (53) by a signal of a signal height (SH_{notch}) different from the signal height (SH) of the sequence (53), and that the radio frequency transmitter (RFT) further comprises connecting means (CM) adapted to provide said transistor circuit (PT) with said modified pulsed bit stream signal (S_{mod}) as the input signal (S_{IN}).

2. The radio frequency transmitter (RFT) of claim 1,
**characterised in**
**that** the control unit (CU) is further adapted to trigger, upon detection of said sequence (53), the generator unit (GU) to insert said one or more notches (531, 532) by generation of one or more signal height discontinuities within the sequence (53) and send the modified pulsed bit stream signal (S_{mod}) via the connecting means (CM) as the input signal (S_{IN}) to the transistor circuit (PT).

3. The radio frequency transmitter (RFT) of claim 1,
**characterised in**
**that** the control unit (CU) is further adapted to initiate, upon detection of said sequence (53), a generation of a trigger signal, and
**that** the connecting means (CM) comprise a switching element (TN) controlled by the trigger signal for the insertion of said notches (531, 532).

4. The radio frequency transmitter (RFT) of claim 3,
**characterised in**
**that** the control unit (CU) is further adapted to trigger, upon detection of said sequence (53), the digital signal generator (DSG) to generate an indicator signal (Sᵢ) for indication of said sequence, and
**that** the radio frequency transmitter (RFT) further comprises a pulse generator (PG) adapted to generate, triggered by said indicator signal (Sᵢ), one or more pulses (Sₙ) as said trigger signal.

5. The radio frequency transmitter of claim 3,
**characterised in**
**that** the radio frequency transmitter (RFT) further comprises a delay unit (L_{d}) adapted to delay the generated trigger signal so that the insertion of said notches (531, 532) occurs at a predefined time.

6. The radio frequency transmitter (RFT) of claim 1,
**characterised in**
**that** a duration (tₙ) of said one or more notches is shorter than a duration (tₚ) of a pulse of the pulsed bit stream signal (S_{DSG}).

7. The radio frequency transmitter (RFT of claim 1,
**characterised in**
**that** said transistor circuit (PT) consists of one or more Gallium nitride transistors.

8. The radio frequency transmitter (RFT) of claim 1,
**characterised in**
**that** the control unit (CU) is further adapted to compensate the insertion of said one or more notches (531, 532) in said sequence (53) by triggering a corresponding extension of the pulsed bit stream signal so that an overall energy content of the pulsed bit stream signal is conserved.

9. The radio frequency transmitter of claim 1,
**characterised in**
**that** the control unit (CU) is further adapted to control a shape of the one or more notches dependent on a type of the switch mode power amplifier (SMPA).

10. A method of amplifying an input signal (S_{IN}) in a radio frequency transmitter (RFT) comprising a switch mode radio frequency power amplifier (SMPA) with a transistor circuit (PT),
**characterised in**
**that** the method comprises the steps of:
detecting in a pulsed bit stream signal (S_{DSG}) a sequence (53) of a constant signal height (SH) longer than a predefined threshold;
initiating, upon detection of said sequence (53), a generation of a modified pulsed bit stream signal (S_{mod}) by an insertion of one or more notches (531, 532) in said sequence (53), said notches (531, 532) interrupting said sequence (53) by a signal of a signal height (SH_{notch}) different from the signal height (SH) of the sequence (53); and
providing said transistor circuit (PT) with said modified pulsed bit stream signal (S_{mod}) as the input signal (S_{IN}).

## Patentansprüche

1. Ein Funkfrequenzsender (RFT), umfassend einen digitalen Signalgenerator (DSG) mit einer für die Erzeugung eines gepulsten Bitstromsignals (S_{DSG}) ausgelegten Generatoreinheit (GU), sowie einen Schaltmodus-Funkfrequenzleistungsverstärker (SMPA) mit einer für die Verstärkung eines Eingangssignals (S_{IN}) ausgelegten Transistorschaltung (PT),
**dadurch gekennzeichnet,**
**dass** der digitale Signalgenerator (DSG) weiterhin eine Steuereinheit (CU) umfasst, welche dazu ausgelegt ist, in dem besagten gepulsten Bitstromsignal (S_{DSG}) eine Sequenz (53) mit einer konstanten Signalhöhe (SH), die einen vorgegebenen Grenzwert überschreitet, zu erkennen und nach dem Erkennen der besagten Sequenz (53) das Erzeugen eines geänderten gepulsten Bitstromsignals (S_{mod}) durch Einfügen einer oder mehrerer Kerben (531, 532) in die besagte Sequenz (53) zu initiieren, wobei die besagten Kerben (531, 532) die besagte Sequenz (53) durch ein Signal mit einer Signalhöhe (SH_{notch}), welche sich von der Signalhöhe (SH) der Sequenz (53) unterscheidet, unterbrechen, und dass der Funkfrequenzsender (RFT) weiterhin Anschlussmittel (CM) umfasst, welche dazu ausgelegt sind, der besagten Transistorschaltung (PT) das besagte geänderte gepulste Bitstromsignal (S_{mod}) als das Eingangssignal (S_{IN}) bereitzustellen.

2. Der Funkfrequenzsender (RFT) nach Anspruch 1,
**dadurch gekennzeichnet,**
**dass** die Steuereinheit (CU) weiterhin dazu ausgelegt ist, nach dem Erkennen der besagten Sequenz (53) die Generatoreinheit (GU) anzusteuern, um die besagte eine oder die besagten mehreren Kerben (531, 532) durch Erzeugen einer oder mehrerer Signalhöhen-Diskontinuitäten in die Sequenz (53) einzufügen und das geänderte gepulste Bitstromsignal (S_{mod}) über die Anschlussmittel (CM) als das Eingangssignal (S_{IN}) an die Transistorschaltung (PT) zu senden.

3. Der Funkfrequenzsender (RFT) nach Anspruch 1,
**dadurch gekennzeichnet,**
**dass** die Steuereinheit (CU) weiterhin dazu ausgelegt ist, nach dem Erkennen der besagten Sequenz (53) ein Erzeugen eines Triggersignals zu initiieren, und
**dass** die Anschlussmittel (CM) ein von dem Triggersignal gesteuertes Schaltelement (TN) zum Einfügen der besagten Kerben (531, 532) umfassen.

4. Der Funkfrequenzsender (RFT) nach Anspruch 3,
**dadurch gekennzeichnet,**
**dass** die Steuereinheit (CU) weiterhin dazu ausgelegt ist, nach dem Erkennen der besagten Sequenz (53) den digitalen Signalgenerator (DSG) anzusteuern, um ein Indikatorsignal (Sᵢ) zum Anzeigen der besagten Sequenz zu erzeugen, und
**dass** der Funkfrequenzsender (RFT) weiterhin einen Impulsgenerator (PG) umfasst, welcher dazu ausgelegt ist, bei Triggern durch das besagte Indikatorsignal (Sᵢ) einen oder mehrere Impulse (Sₙ) als das besagte Triggersignal zu erzeugen.

5. Der Funkfrequenzsender (RFT) nach Anspruch 3,
**dadurch gekennzeichnet,**
**dass** der Funkfrequenzsender (RFT) weiterhin eine Verzögerungseinheit (L_{d}) umfasst, welche dazu ausgelegt ist, dass erzeugte Triggersignal derart zu verzögern, dass das Einfügen der besagten Kerbe (531, 532) zu einem vorgegeben Zeitpunkt erfolgt.

6. Der Funkfrequenzsender (RFT) nach Anspruch 1,
**dadurch gekennzeichnet,**
**dass** die Zeitdauer (tₙ) der besagten einen oder der besagten mehreren Kerben kürzer ist als eine Zeitdauer (tₚ) eines Pulses des gepulsten Bitstromsignals (S_{DSG}) ist.

7. Der Funkfrequenzsender (RFT) nach Anspruch 1,
**dadurch gekennzeichnet,**
**dass** die besagte Transistorschaltung (PT) aus einem oder mehreren Galliumnitrid-Transistoren besteht.

8. Der Funkfrequenzsender (RFT) nach Anspruch 1,
**dadurch gekennzeichnet,**
**dass** die Steuereinheit (CU) weiterhin dazu ausgelegt ist, das Einfügen der besagten einen oder der besagten mehreren Kerben (531, 532) in die besagte Sequenz (53) durch Triggern einer entsprechenden Erweiterung des gepulsten Bitstromsignals zu kompensieren, so dass ein Gesamtenergieanteil des gepulsten Bitstromsignals erhalten bleibt.

9. Der Funkfrequenzsender (RFT) nach Anspruch 1,
**dadurch gekennzeichnet,**
**dass** die Steuereinheit (CU) weiterhin für das Steuern einer Form der einen oder der mehreren Kerben gemäß einem Typ des Schaltmodus-Funkfrequenzleistungsverstärkers (SMPA) ausgelegt ist.

10. Ein Verfahren zur Verstärkung eines Eingangssignals (S_{IN}) in einem Funkfrequenzsender (RFT), welcher einen Schaltmodus-Funkfrequenzleistungsverstärker (SMPA) mit einer Transistorschaltung (PT) umfasst,
**dadurch gekennzeichnet,**
**dass** das Verfahren die folgenden Schritte umfasst:
Erkennen, in einem gepulsten Bitstromsignal (S_{DSG}), einer Sequenz (53), deren konstante Signalhöhe (SH) den vorgegebenen Grenzwert überschreitet;
Initiieren, nach Erkennen der besagten Sequenz (53), einer Erzeugung eines geänderten gepulsten Bitstromsignals (S_{mod}) durch Einfügen einer oder mehrerer Kerben (531, 532) in die besagte Sequenz (53), wobei die besagten Kerben (531, 532) die besagte Sequenz (53) durch ein Signal, dessen Signalhöhe (SH_{notch}) sich von der Signalhöhe (SH) der Sequenz (53) unterscheidet, unterbrechen; und
Bereitstellen des besagten geänderten gepulsten Bitstromsignals (S_{mod}) als das Eingangssignal (S_{IN}) an die Transistorschaltung (PT).

## Revendications

1. Emetteur radiofréquence (RFT) comprenant un générateur de signaux numériques (DSG) et une unité de génération (GU) adaptés pour générer un signal de flux binaire pulsé (Soso) ainsi qu'un amplificateur de puissance radioélectrique en mode commuté (SMPA) et un circuit à transistors (PT) adapté pour amplifier un signal d'entrée (SIN),
**caractérisé en ce**
**que** le générateur de signaux numériques (DSG) comprend en outre une unité de commande (CU) adaptée pour détecter, dans le signal de flux binaire pulsé (S_{DSO}), une séquence (53) d'une hauteur de signal constante (SH) supérieure à un seuil prédéfini et pour initier, suite à la détection de ladite séquence (53), la génération d'un signal de flux binaire pulsé modifié (S_{mod}) en insérant une ou plusieurs encoches (531, 532) dans ladite séquence (53), lesdites encoches (531, 532) venant interrompre ladite séquence (53) par un signal d'une hauteur de signal (SH_{notch}) différente de la hauteur de signal (SH) de la séquence (53), et en ce que l'émetteur radiofréquence (RFT) comprend en outre des moyens de connexion (CM) adaptés pour fournir audit circuit à transistors (PT) ledit signal de flux binaire pulsé modifié (S_{mod}) en tant que signal d'entrée (S_{IN}).

2. Emetteur radiofréquence (RFT) selon la revendication 1,
**caractérisé en ce**
**que** l'unité de commande (CU) est en outre adaptée pour déclencher, suite à la détection de ladite séquence (53), l'unité de génération (GU) pour insérer ladite ou lesdites encoches (531, 532) en générant une ou plusieurs discontinuités de hauteur de signal au sein de la séquence (53) et pour envoyer au circuit à transistors (PT) le signal de flux binaire pulsé modifié (Smog) en tant que signal d'entrée (S_{IN}) par l'intermédiaire des moyens de connexion (CM).

3. Emetteur radiofréquence (RFT) selon la revendication 1,
**caractérisé en ce**
**que** l'unité de commande (CU) est en outre adaptée pour initier, suite à la détection de ladite séquence (53), la génération d'un signal de déclenchement, et
en ce que les moyens de connexion (CM) comprennent un élément de commutation (TN) commandé par le signal de déclenchement pour insérer lesdites encoches (531, 532).

4. Emetteur radiofréquence (RFT) selon la revendication 3,
**caractérisé en ce**
**que** l'unité de commande (CU) est en outre adaptée pour déclencher, suite à la détection de ladite séquence (53), le générateur de signaux numériques (DSG) afin de générer un signal d'indication (Sᵢ) pour indiquer ladite séquence, et
en ce que l'émetteur radiofréquence (RFT) comprend en outre un générateur d'impulsions (PG) adapté pour générer, une fois déclenché par ledit signal d'indication (Si), une ou plusieurs impulsions (Sn) en tant que signal de déclenchement.

5. Emetteur radiofréquence (RFT) selon la revendication 3,
**caractérisé en ce**
**que** l'émetteur radiofréquence (RFT) comprend en outre un circuit à retard (Ld) adapté pour retarder le signal de déclenchement généré de manière à ce que l'insertion desdites encoches (531, 532) se produise à une heure prédéfinie.

6. Emetteur radiofréquence (RFT) selon la revendication 1,
**caractérisé en ce**
**que** la durée (tₙ) de ladite ou desdites encoches est inférieure à la durée (tₚ) d'une impulsion du signal de flux binaire pulsé (S_{DSG}).

7. Emetteur radiofréquence (RFT) selon la revendication 1,
**caractérisé en ce**
**que** ledit circuit à transistors (PT) est composé d'un ou plusieurs transistors au nitrure de Gallium.

8. Emetteur radiofréquence (RFT) selon la revendication 1,
**caractérisé en ce**
**que** l'unité de commande (CU) est en outre adaptée pour compenser l'insertion de ladite ou desdites encoches (531; 532) dans ladite séquence (53) en déclenchant une extension correspondante du signal de flux binaire pulsé de manière à conserver le contenu énergétique global du signal de flux binaire pulsé.

9. Emetteur radiofréquence (RFT) selon la revendication 1,
**caractérisé en ce**
**que** l'unité de commande (CU) est en outre adaptée pour commander la forme de ladite ou desdites encoches selon un type d'amplificateur de puissance en mode commuté (SMPA).

10. Procédé d'amplification d'un signal d'entrée (Sᵢn) dans un émetteur radiofréquence (RFT) comprenant un amplificateur de puissance radioélectrique en mode commuté (SMPA) avec un circuit à transistors (PT),
**caractérisé en ce**
**que** le procédé comprend les étapes suivantes : détection, dans un signal de flux binaire pulsé (S_{DSG}) d'une séquence (53) d'une hauteur de signal constante (SH) supérieure à un seuil prédéfini ; initiation, suite à la détection de ladite séquence (53), de la génération d'un signal de flux binaire pulsé modifié (Smog) par l'insertion d'une ou de plusieurs encoches (531, 532) dans ladite séquence (53), lesdites encoches (531, 532) venant interrompre ladite séquence (53) par un signal d'une hauteur de signal (SH_{notch}) différente de la hauteur de signal (SH) de la séquence (53) ; et fourniture audit circuit à transistors (PT) dudit signal de flux binaire pulsé modifié (S_{mod}) en tant que signal d'entrée (SIN).
